# EUROPEAN PATENT APPLICATION

(11) **EP 4 687 378 A1**
(43) Date of publication of application: **04.02.2026**
(21) Application number: 24191625.3
(22) Date of filing: 30.07.2024
(51) Int. Cl.: H05K 7/20, H05K 9/00, H01L 23/367

(54) **ELECTRONIC DEVICE**

(71) Applicant: Aptiv Technologies AG, 8200 Schaffhausen (CH)
(72) Inventor: BARUS, Lukasz, 8200 Schaffhausen (CH); MISIORNY, Jakub, 8200 Schaffhausen (CH); ADAMCZYK, Krzysztof, 8200 Schaffhausen (CH)
(74) Representative: Manitz Finsterwald Patent- und Rechtsanwaltspartnerschaft mbB

(57) **Abstract**

An electronic device comprises at least one electronic component arranged on a circuit board and a heat sink conductively connected to the at least one electronic component. The electronic device further comprises at least one electroconductive elastic element attached to the heat sink and the circuit board, wherein the at least one electroconductive elastic element is configured to shield the at least one electronic component against electromagnetic emission.

## Description

### FIELD

The present disclosure relates to an electronic device, in particular to local shielding of electronic components of the electronic device and heat dissipation of the electronic device.

### BACKGROUND

Electromagnetic emission can affect electronic components of an electronic device and can cause a variety of different issues, from a simple noise on a communication line to a complete interruption of a safety-critical signal.

A main purpose of an effective Electro-Magnetic Compatibility (EMC) shielding is to prevent electromagnetic interference (EMI) or radio frequency interference (RFI) from impacting electronic components of an electronic device.

Overheating of electronic components can also be a serious problem for electronic devices. In particular, a functionality of heat-generating electronic components may be impaired if the electronic components become too hot, i.e. the heat cannot be dissipated sufficiently from the electronic component.

Therefore, known electronic devices may include heat transfer means for the heat transfer of the electronic components without any local EMC shielding means or local EMC shielding means without any thermal transfer means.

For demanding EMC requirements where an integrated circuit (IC) or another electronic component of an electronic device has to be shielded locally but also may overheat without a heat sink support, however, some compromises usually have to be made. Either software degradation has to be accepted or additional multi point grounding (GND) pedestals have to be attached around the IC or the electronic component of the electronic device.

Therefore, a choice has to be made between adequate and sufficient thermal management of an electronic device or adequate shielding of the electronic components of the electronic device in case of excessive emission or the occurrence of parasitic electronic elements.

Accordingly, there is a need for an electronic device that includes appropriate and sufficient thermal management and adequate effective shielding against electromagnetic emissions.

### SUMMARY

The present disclosure provides an electronic device according to the independent claim. Embodiments are given in the subclaims, the description and the drawings.

In one aspect, the present disclosure is directed at an electronic device comprising at least one electronic component, a heat sink and at least one electroconductive elastic element. The at least one electronic component is arranged on a circuit board. The heat sink is conductively connected to the at least one electronic component. The at least one electroconductive elastic element is attached to the heat sink and the circuit board, wherein the at least one electroconductive elastic element is configured to shield the at least one electronic component against electromagnetic emission.

The electronic device may include a plurality of electronic components, wherein each or at least one of the electronic components generates heat. The electronic device may be part of a vehicle, for example, the electronic device may be a control unit. The at least one electronic component may be any type of electronic component that generates heat, for example a microcontroller, a processor or the like. In particular, the at least one electronic component may be an active electronic component, comprising, for example a transistor, an integrated circuit or the like. The at least one electronic component may be electrically connected to the circuit board by supplying the at least one electronic component with power from the circuit board.

The heat sink may comprise a material with a thermal conductivity of at least 100 W/(m K), preferably of at least 200 W/(m. K). In particular, the heat sink may be made of metal material, such as copper, aluminum or an alloy thereof. The heat sink may be thermally connected to the at least one electronic component. The heat sink may be configured to transport heat from the at least one electronic component. This may allow the at least one electronic component to be cooled by the heat sink. The heat sink may be formed as a single piece. Alternatively, the heat sink may be formed as separate parts.

The at least one electroconductive elastic element may be made of an electroconductive material, such as metal. The at least one electroconductive elastic element may electrically connect the heat sink to the circuit board. The at least one electroconductive elastic element may be attached to the heat sink by being a part of the heat sink. Alternatively, the at least one electroconductive elastic element may be pressed against the heat sink in an assembled state of the electronic device. The at least one electroconductive elastic element may be soldered to the circuit board or pressed against the circuit board in an assembled state of the electronic device.

The at least one electroconductive elastic element may be configured to locally shield the at least one electronic component against electromagnetic emission, i.e. only the at least one electronic component may be shielded by the at least one electroconductive elastic element. It is to be understood that a second electronic component or a plurality of electronic components may be shielded against electromagnetic emission by the at least one electroconductive elastic element, by a second electroconductive elastic element, or by a plurality of electroconductive elastic elements. Thus, each electronic component of the electronic device may be locally shielded by the at least one electroconductive elastic element or by a respective electroconductive elastic element. The shielding of the at least one electronic component against electromagnetic emission may mean that a functionality of the at least one electronic component is not affected by electromagnetic emission from the electronic component itself or from other electronic components of the electronic device.

According to an embodiment, the electronic device further comprises at least one pedestal. The at least one pedestal is arranged between the at least one electronic component and the heat sink. The at least one pedestal is conductively attached to the at least one electronic component and the heat sink. The pedestal may be a part of the heat sink. The pedestal may also comprise a material with a thermal conductivity of at least 100 W/(m K), preferably of at least 200 W/(m K). The pedestal may be made of the same material as the heat sink or of a different material as the heat sink. In particular, the pedestal may be a full metal pedestal for heat transfer. Thus, generated heat from the at least one electronic component may be transferred or dissipated from the electronic component to the heat sink via the pedestal. The at least one pedestal may be thermally connected to the at least one electronic component at one end of the pedestal and thermally connected to the heat sink at an opposite end of the pedestal. The electronic device may comprise one heat sink and a plurality of pedestals, wherein each of the plurality of pedestals may be connected to a respective electronic component of the electronic device and to the heat sink.

According to this embodiment, the at least one pedestal is configured to transfer heat from the at least one electronic component to the heat sink. The at least one pedestal is thermally connected to the electronic component and to the heat sink. The at least one pedestal may be made of the same material as the heat sink, having the same thermal conductivity. However, the at least one pedestal may be made of a different material as the heat sink, having a different thermal conductivity. Heat dissipation of the at least one electronic component may avoid functional limitations of the electronic device.

According to an embodiment, the at least one electroconductive elastic element is attached to the at least one pedestal and the circuit board. The at least one electroconductive elastic element may be attached at a first end of the pedestal that is in contact with the electronic component. Thus, a shortest possible path for eliminating electromagnetic interference may be possible. Alternatively, the at least one electroconductive elastic element may be attached to the pedestal at a second end of the pedestal that is in contact with the heat sink. The at least one electroconductive elastic element may also be attached to the pedestal in between the first end of the pedestal and the second end of the pedestal.

The at least one electroconductive elastic element is electrically conductive connected to the pedestal. The at least one electroconductive elastic element may be attached to the at least one pedestal by being a part of the at least one pedestal, as described in more detail below. Alternatively, the at least one electroconductive elastic element may be pressed against the at least one pedestal in an assembled state of the electronic device.

The at least one electroconductive elastic element is electrically conductive connected to the circuit board. The at least one electroconductive elastic element may be soldered to the circuit board or pressed against the circuit board in an assembled state of the electronic device. In particular, the at least one electroconductive elastic element may be soldered to the circuit board if the at least one electroconductive elastic element is a separate means, and the at least one electroconductive elastic element may be pressed against the circuit board if the at least one electroconductive elastic element is a part of the at least one pedestal.

According to an embodiment, the at least one electroconductive elastic element is a part of the at least one pedestal. In particular, the at least one electroconductive elastic element may be formed from a part of a wall of the at least one pedestal. The part of the wall may be punched out of the wall of the at least one pedestal and formed such that the part is still connected at one end of the part to the pedestal and on another end to the circuit board. Thus, there is no need for a separate electroconductive elastic element which reduces complexity of the electronic device.

According to an embodiment, the at least one electroconductive elastic element is a separate means attached to the at least one pedestal. The at least one electroconductive elastic element may comprise a spring or a foam, wherein the spring or the foam are made of a conductive material, for example a conductive metal. The at least one electroconductive element may comprise an opening. In particular, one end of the at least one electroconductive element may form the opening. The at least one electroconductive element may be attached to the at least one pedestal at the opening. In particular, the at least one pedestal may be passed through the opening such that the at least one pedestal contacts the one end of the at least one electroconductive element that forms the opening.

According to an embodiment, the at least one pedestal extends between the at least one electronic component and the heat sink along an axis and is in thermal contact with the at least one electronic component and the heat sink. The axis may be arranged perpendicular to the circuit board and/or to the at least one electronic component. The at least one pedestal may be cylindrical, conical or cuboid in shape. In particular, the at least one pedestal may have a smaller cross-section at the first end that is connected to the at least one electronic component than at the second end that is connected to the heat sink. Thus, sufficient heat transfer may prevent overheating of the at least one electronic component.

According to an embodiment, the electronic device further comprises a thermal interface material arranged between the at least one electronic component and the at least one pedestal. The thermal interface material may be a dielectric material. The dielectric thermal interface material may have a thermal conductivity of at least 2 W/(m K), preferably of at least 5 W/(m K) and more preferably of more than 10 W/(m K). The thermal interface material may also be any other kind of conventional thermal interface material, such as, but not limited to, a thermal paste, a thermal adhesive, a thermal tape or the like.

The thermal interface material may be configured to conduct heat from the at least one electronic component to the heat sink or to the pedestal. Thus, the thermal interface material may further improve cooling the at least one electronic component.

According to an embodiment, the at least one electroconductive elastic element comprises a first end and a second end, wherein the first end of the at least one electroconductive elastic element comprises a first elastic element configured to connect the first end of the at least one electroconductive elastic element to the at least one pedestal, and wherein the second end of the at least one electroconductive elastic element comprises a second elastic element configured to connect the second end of the at least one electroconductive elastic element to the circuit board.

It is to be understood that also a middle section of the at least one electroconductive elastic element, arranged between the first end of the at least one electroconductive elastic element and the second end of the at least one electroconductive elastic element, may be formed elastically. However, the middle section of the at least one electroconductive elastic element may also be formed as a rigid, non-flexible element.

According to an embodiment, the at least one electroconductive elastic element is attached to the circuit board such that the at least one electroconductive elastic element is grounded to the circuit board. The at least one electroconductive elastic element is electrically conductively connected to the circuit board. The circuit board may be grounded in that unwanted electricity may be eliminated by grounding. Grounding may be reached by a common return path for electric current or a direct physical connection to the earth. Therefore, electromagnetic emission may be eliminated by grounding.

According to an embodiment, the at least one electroconductive elastic element is configured to ground current loops escaping from the at least one electronic component back to a grounding of the circuit board. Undesirable current that escapes from the at least one electronic component may be electrically conducted from the at least one electronic component via the pedestal through the at least one electroconductive elastic element to the grounding of the circuit board. A negative influence from the electromagnetic emission of the undesirable current may, thus, be avoided.

According to an embodiment, the at least one electroconductive elastic element is configured to compensate tolerances at respective connection points between the at least one electroconductive elastic element and the at least one pedestal and between the at least one electroconductive elastic element and the circuit board.

The first elastic element at the first end of the electroconductive elastic element may form the opening of the electroconductive elastic element through which the at least one pedestal extends. A risk of unwanted gaps between the electroconductive elastic element and the at least one pedestal may be minimized by the first elastic element that is in contact with the at least on pedestal passing through the opening formed by the first elastic element since the self-aligning first elastic element may compensate tolerances between the electroconductive elastic element and the at least one pedestal.

The second elastic element at the second end of the electroconductive elastic element may also minimize a risk of unwanted gaps between the electroconductive elastic element and the circuit board since the self-aligning second elastic element may compensate tolerances between the electroconductive elastic element and the circuit board

According to an embodiment, the at least one electroconductive elastic element is arranged around the at least one electronic component. The at least one electroconductive elastic element encompassed the at least one electronic component. Thus, the at least one electronic component may be prevented against electromagnetic emissions from all sides of the at least one electronic component.

According to an embodiment, the electronic device comprises a plurality of electronic components arranged spaced apart on the circuit board and the at least one electroconductive elastic element is arranged around the plurality of electronic components, wherein the at least one electroconductive elastic element is configured to shield the plurality of electronic components from electromagnetic emission. Each electronic component of the plurality of electronic components may be electrically connected to the at least one electroconductive elastic element. Therefore, a current of each electronic component of the plurality of electronic components may be looped back to the circuit board, in particular to the grounding of the circuit board, via the pedestal in a shortest possible way. The at least one electroconductive elastic element may be grounded to circuit board by an electrical connection of the at least one electroconductive elastic element to the circuit board.

According to an embodiment, the electronic device comprises a plurality of pedestals, each of the plurality of pedestals being arranged between a respective electronic component of the plurality of electronic components and the heat sink, and wherein the at least one electroconductive elastic element is attached to each pedestal of the plurality of pedestals and the circuit board. Thus, a plurality of electronic components may be protected against overheating and shielded against electromagnetic emissions using the plurality of pedestals and the at least one electroconductive elastic element.

### DRAWINGS

Exemplary embodiments and functions of the present disclosure are described herein in conjunction with the following drawings, showing schematically:
- Fig. 1: a cross-sectional view of an electronic device according to an embodiment;
- Fig. 2: a top-view of the electronic device of Fig. 1;
- Fig. 3: a further cross-sectional view of the electronic device of Fig. 1 with tolerance compensation using elastic elements;
- Fig. 4: a further cross-sectional view of the electronic device of Fig. 1 with a principal of local grounding; and
- Fig. 5: a perspective view of an electronic device according to another embodiment comprising a plurality of electronic components.

### DETAILED DESCRIPTION

Electronic devices may include a plurality of heat-generating electronic components, wherein excessive heat may affect the behavior of the electronic components. In addition, the electronic components may be sensitive to electromagnetic emissions generated either by themselves or by other electronic components.

The problem of overheating of the electronic components may be solved by a full metal pedestal for heat transfer from the electronic components to a heat sink, while the electronic components may be protected against electromagnetic emission by shielding.

An electronic device as described herein may combine these two effects and provide local shielding for the electronic components of the electronic device together with a pedestal for heat transfer.

The problem of meeting both requirements, thermal management and local shielding of the electronic component, that applies to an integrated circuit (IC) or any other electronic component on a printed circuit board (PCB) is solved by incorporating a local designated (EMC-)shielding that interacts with a pedestal for heat transfer so that heat transfer is not affected and proper grounding and attenuation of electromagnetic emission is still obtained.

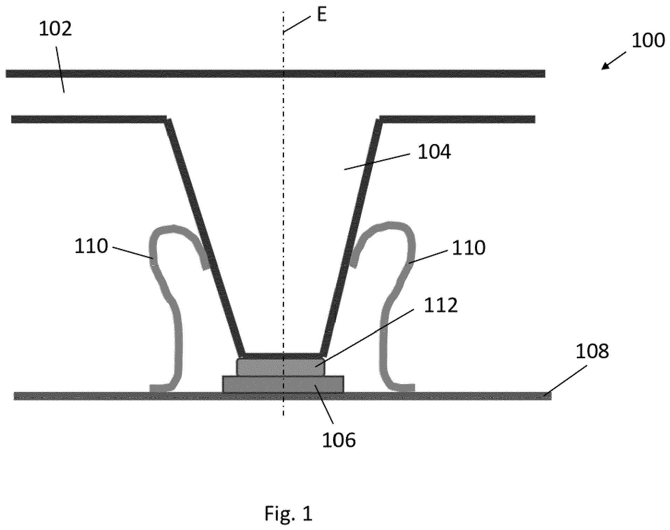

Fig. 1 shows a cross-sectional view of an electronic device 100 according to an embodiment. The electronic device 100 includes an electronic component 106 arranged on a circuit board 108. The electronic device 100 further includes a heat sink 102 conductively connected to the electronic component 106. In particular, the electronic device 100 includes a pedestal 104 arranged between the electronic component 106 and the heat sink 102, wherein the pedestal 104 is conductively attached to the electronic component 106 and the heat sink 102. The pedestal 104 extends between the electronic component 106 and the heat sink 102 along an axis E. Further, the pedestal 104 is in thermal contact with the electronic component 106 and the heat sink 102.

The pedestal 104 is configured to transfer heat generated from the electronic component 106 to the heat sink 102. As shown in Fig. 1, the electronic device 100 may further include a thermal interface material 112 arranged between the electronic component 106 and the pedestal 104. The thermal interface material 112 may improve the heat transfer from the electric component 106 to the pedestal 104 and to the heat sink 102.

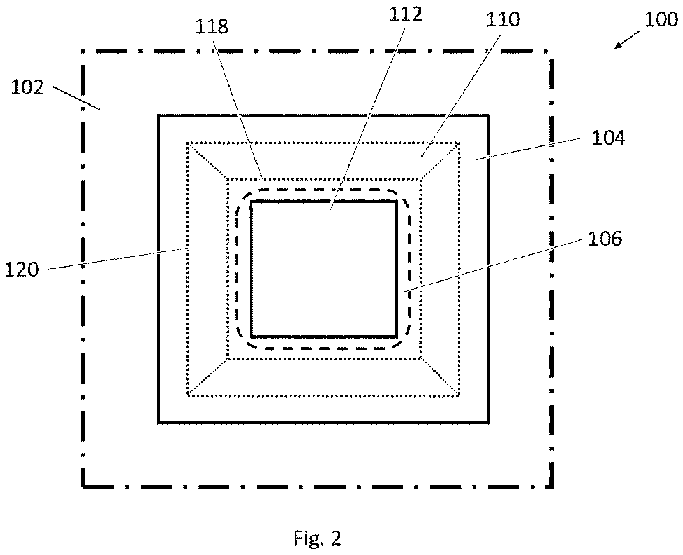

The electronic device 100 further includes an electroconductive elastic element 110 attached to the heat sink 102, in particular attached to the pedestal 104, and the circuit board 108, wherein the electroconductive elastic element 110 is configured to shield the electronic component 106 from electromagnetic emission. The electroconductive elastic element 110 may be configured to provide local Electro-Magnetic Compatibility (EMC) shielding to the electronic component 106 as will be described in more detail in Fig. 2.

The heat sink 102 may be attached to a housing (not shown in Fig. 1) of the electronic device 100, or may be part of the housing. The pedestal 104 may reach from the housing to the electronic component 106.

Fig. 2 shows a top-view of the electronic device 100 of Fig. 1. The pedestal 104 reaches from the heat sink 102 down to the electronic component 106 or to the thermal interface material 112. The electroconductive elastic element 110 shown as dotted lines in Fig. 2 is arranged between the pedestal 104 and the circuit board 108 (not shown in Fig. 2). The electroconductive elastic element 110 is arranged around the electronic component 106. Thus, local electric shielding of the electronic component 106 may be achieved by the electroconductive elastic element 110. The electroconductive elastic element 110 may include an opening 118, wherein the pedestal 104 extends through the opening 118 and is connected to the electroconductive elastic element 110 at the opening 118. The electroconductive elastic element 110 may further include a base 120, wherein the electroconductive elastic element 110 is connected to the circuit board 108 at the base 120. The base 120 of the electroconductive elastic element 110 may completely surround the electronic component 106. Therefore, shielding of the electronic component 106 against electromagnetic emission may be possible from all sides of the electronic component 106.

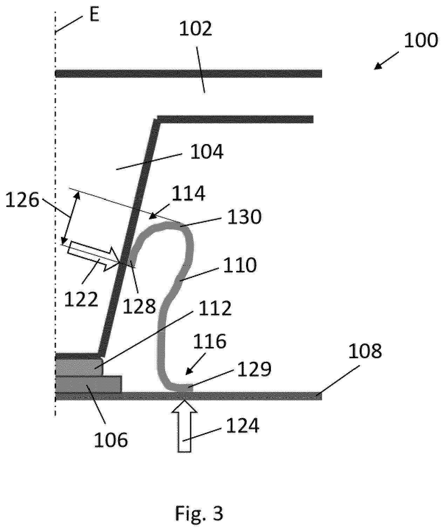

Fig. 3 shows a further cross-sectional view of the electronic device 100 with tolerance compensation using elastic elements. The pedestal 104 extends between the electronic component 106, in particular between the thermal interface material 112 and the heat sink 102 along the axis E. The axis E may be an axis of symmetry of the electronic device 100.

The electroconductive elastic element 110 is attached to the pedestal 104 and the circuit board 108. As shown in Fig. 3, the electroconductive elastic element 110 is a separate means attached to the pedestal 104. In particular, the electroconductive elastic element 110 may include a first end 114 and a second end 116, wherein the first end 114 of the electroconductive elastic element 110 is in contact with the pedestal 104 and the second end 116 of the electroconductive elastic element 110 is in contact with the circuit board 108. The electroconductive elastic element 110 may be formed in S-shape. However, it is to be understood that also other shapes for the electroconductive elastic element 110 are generally possible as long as the first end 114 of the electroconductive elastic element 110 connects to the pedestal 104 and the second end 116 of the electroconductive elastic element 110 connects to the circuit board 108.

In another embodiment, the electroconductive elastic element 110 may be a part of the pedestal 104. The part of the pedestal 104 may be a part of a wall of the pedestal 104, wherein the part of the wall may be punched out of the wall such that only the first end 114 of the electroconductive elastic element 110 remains attached to the pedestal 104. The remainder of the part may be formed in a S-shape as shown in Fig. 3, wherein the second end 116 of the electroconductive elastic element 110 is attached to the circuit board 108.

The first end 114 of the electroconductive elastic element 110 may include a first elastic element configured to connect the first end 114 of the electroconductive elastic element 110 to the pedestal 104. The second end 116 of the electroconductive elastic element 110 may include a second elastic element configured to connect the second end 116 of the electroconductive elastic element 110 to the circuit board 108.

As shown in Fig. 3, a first reaction force 122 may occur between the first end 114 of the electroconductive elastic element 110 and the pedestal 104 if the pedestal 104 is in contact with the first end 114 of the electroconductive elastic element 110 and the pedestal 104 passes through the opening 120 (see Fig. 2) of the electroconductive elastic element 110 formed by the first end 114 of the electroconductive elastic element 110.

Also, a second reaction force 124 may occur between the second end 116 of the electroconductive elastic element 110 and the circuit board 108, once the second end 116 of the electroconductive elastic element 110 is connected to the circuit board 108 and the pedestal 104 is installed on the electronic component 106 and in contact to the first end 114 of the electroconductive elastic element 110.

A distance 126 between a first connection point 128 and a reversal point 130 of the electroconductive elastic element 110 may be dimensioned such that a tolerance of the pedestal 104 may be compensated. The distance 126 may be between 0,1 mm and 0,5 mm, in particular between 0,1 mm and 0,3 mm, preferably 0,2 mm. The first connection point 128 may define a point or an area where the first end 114 of the electroconductive elastic element 110 contacts the pedestal 104. The reversal point 130 may define a point or an area at the first end 114 of the S-shaped electroconductive elastic element 110 where the electroconductive elastic element 110 change a direction, for example a maximum turning point of the S-shape structure. The greater the distance 126, the more flexible the first end 114 of the electroconductive elastic element 110 may be. The electroconductive elastic element 110, in particular the first elastic element arranged at the first end 114 of the electroconductive elastic element 110 may be configured to compensate tolerances at the connection point 128 between the electroconductive elastic element 110 and the pedestal 104. By compensation the tolerances between the electroconductive elastic element 110 and the pedestal 104, there may be no gap between the pedestal 104 and the electroconductive elastic element 110 when the pedestal 104 is installed, i.e. when the pedestal 104 passes through the opening of the electroconductive elastic element 110 and is in contact with the electronic component 106.

The electroconductive elastic element 110, in particular the second elastic element arranged at the second end 116 of the electroconductive elastic element 110 may be configured to compensate tolerances at the connection point 129 between the electroconductive elastic element 110 and the circuit board 108. By compensation the tolerances between the electroconductive elastic element 110 and the circuit board 108, there may be no gap between the electroconductive elastic element 110 and the circuit board 108 when the electroconductive elastic element 110 is installed, i.e. when the electroconductive elastic element 110 is in contact to the pedestal 104 and to the circuit board 108.

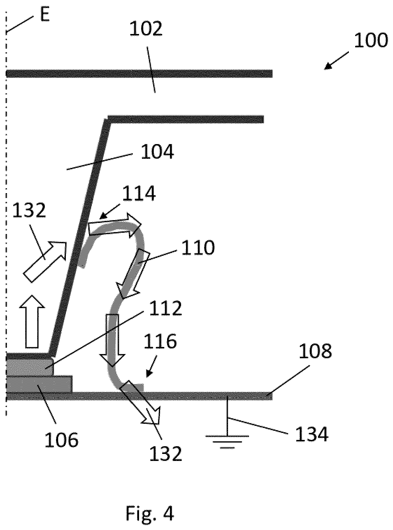

Fig. 4 shows a further cross-sectional view of the electronic device 100 with a principal of local grounding. The features shown in Fig. 4 correspond to the features shown in Fig. 3, wherein the features are not described again for reasons of efficiency. In addition to Fig. 3, a current flow 132 is shown by a plurality of arrows in Fig. 4. The current flow 132 marks a current flowing from the electronic component 106 via the pedestal 104 and the electroconductive elastic element 100 back to the circuit board 108. Since the electroconductive elastic element 110 is in contact with the pedestal 104 and not with the heat sink 102 directly, the current flow 132 defines a shortest possible way from the electronic component 106 to a grounding 134 of the circuit board 108.

The electroconductive elastic element 110 is attached to the circuit board 108 such that the electroconductive elastic element 110 is grounded to the circuit board 108. In particular, the electroconductive elastic element 110 is configured to ground current loops escaping from the electronic component 106 back to the grounding 134 of the circuit board 108, as illustrated by the current flow 132 in Fig. 4. The grounding of the current emerging from the electronic component 106 may shield the electronic component 106 against electromagnetic emission.

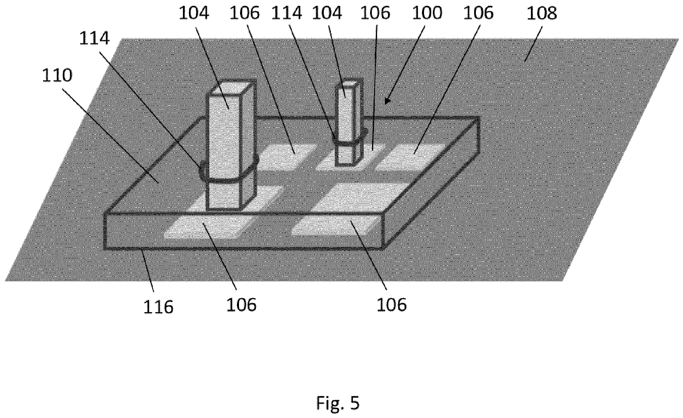

Fig. 5 shows a perspective view of an electronic device 100 according to another embodiment comprising a plurality of electronic components 106. The electronic device 100 inlcudes a plurality of electronic components 106 arranged spaced apart on the circuit board 108. The electroconductive elastic element 110 is arranged around the plurality of electronic components 106 in that the electroconductive elastic element 110 encompasses all electronic components 106 of the plurality of electronic components 106. The electroconductive elastic element 110 is configured to shield the plurality of electronic components 106 against electromagnetic emission. In particular, the electroconductive elastic element 110 is configured to shield each electronic component 106 of the plurality of electronic components 106 against electromagnetic emission.

The electronic device 100 includes two pedestals 104 for heat dissipation of a respective electronic component 106, wherein each of the two pedestals 104 is arranged between the respective electronic component 106 of the plurality of electronic components 106 and a heat sink 102 (not shown in Fig. 5). In particular, each of the two pedestal 104 is thermally connected to the respective heat-generating electronic component 106 and the heat sink 102. A thermal interface material 112 (see Fig. 1) may be arranged between the respective heat-generating electronic component 106 and the pedestal 104.

The electronic device 100 also includes non-heat-generating electronic components 106. The non-heat-generating electronic components 106 are not connected to one of the two pedestals 104. However, the electroconductive elastic element 110 also encompasses the non-heat-generating electronic components 106. Therefore, the non-heat-generating electronic components 106 are also shielded against electromagnetic emission by the electroconductive elastic element 110.

The electroconductive elastic element 110 is attached to each of the two pedestals 104 at a respective first end 114 of the electroconductive elastic element 110 and to the circuit board 108 at a second end 116 of the electroconductive elastic element 110. The electroconductive elastic element 110 may be configured as described in Figs. 1 to 4 and may not be described for the embodiment of Fig. 5 again for reasons of efficiency.

In summary, an original or a standard pedestal 104 can be used and additionally provided with local EMC shielding by using an electroconductive elastic element 110 designated for one electronic component 106 or a plurality of electronic components 106 distributed on a circuit board 108, for example a printed circuit board (PCB).

The pedestal 104 is thermally connected to a heat sink 102 and extends from the heat sink 102 down to the electronic component 106. The pedestal 104 is also thermally connected to the electronic component 106, which may be required in case of proper thermal management of the electronic component 106. Therefore, a sufficient heat transfer from the electronic component 106 to the heat sink 102 may prevent overheating of the electronic component 106.

On the other hand, the local EMC shielding may protect the electronic component 106 from excessive electromagnetic (EM) emission by grounding any possible current loops that may lead from the electronic component 106 through the pedestal 104 back to a nearby grounding 134 of the circuit board 108.

A connection between the electroconductive elastic element 110 and the pedestal 104 is made by a designated opening 118 at a first end 114 of the electroconductive elastic element 110. The opening 118 or the first end 114 of the electroconductive elastic element 110 may include elastic elements. The elastic elements may be formed directly from walls of the pedestal 104 or may be added as separate means, for example springs or foams, that allow current to be returned from the pedestal 104 back to the circuit board 108 in a shortest possible way.

A second end 116 of the electroconductive elastic element 110 is provided with a corresponding interface to the circuit board 108 which allows the electroconductive elastic element 110 to be grounded to the circuit board 108 by an elastic element formed from the wall of the pedestal 104 or an additional separate means, for example a spring or a foam.

By including elastic elements at both ends of the shielding or both ends of the electroconductive elastic element 110, a plurality of pedestals 104 may be passed through the shielding or the electroconductive elastic element 110 by separate openings 118 without a risk of creating unwanted gaps. Thus, tolerances may be compensated by the self-aligning elastic elements.

This invention combines both a pedestal 104 without any size limitation for heat transfer of an electronic component 106 and a fully functional EMC shielding by using an electroconductive elastic element 110 in one functional feature for one or more electronic components 106 in an electronic device 100. Thus, a generation of parasitic elements may be prevented and pedestals 104 may still be incorporated for heat transfer of the electronic component 106.

The invention may both simplify a design of an electronic device 100 and mitigate potential issues related to thermal or EMC management of the electronic device 100, as both features may be utilized simultaneously. Design iteration loops may also be shortened by new possibilities of dealing with excessive emissions. Other departments, such as a software department, may not have to deal with adjusting the parameters of an integrated circuit (IC), e.g. the clock frequency. Degradation of the software to mitigate certain risks may be avoided so that the quality of a product for an end user of the product may not be compromised.

### Reference numeral list

- 100: electronic device
- 102: heat sink
- 104: pedestal
- 106: electronic component
- 108: circuit board
- 110: electroconductive elastic element
- 112: thermal interface material
- 114: first end of electroconductive elastic element
- 116: second end of electroconductive elastic element
- 118: opening
- 120: base
- 122: reaction force
- 124: reaction force
- 126: distance
- 128: first connection point
- 129: second connection point
- 130: reversal point
- 132: current flow
- 134: grounding

- E: axis

## Claims

1. Electronic device (100) comprising:
- at least one electronic component (106) arranged on a circuit board (108);
- a heat sink (102) conductively connected to the at least one electronic component (106); and
- at least one electroconductive elastic element (110) attached to the heat sink (102) and the circuit board (108),
wherein the at least one electroconductive elastic element (110) is configured to shield the at least one electronic component (106) against electromagnetic emission.

2. Electronic device (100) according to claim 1, further comprising:
- at least one pedestal (104) arranged between the at least one electronic component (106) and the heat sink (102), wherein the at least one pedestal (104) is conductively attached to the at least one electronic component (106) and the heat sink (102).

3. Electronic device (100) according to claim 2,
wherein the at least one pedestal (104) is configured to transfer heat from the at least one electronic component (106) to the heat sink (102).

4. Electronic device (100) according to at least one of claims 2 or 3,
wherein the at least one electroconductive elastic element (110) is attached to the at least one pedestal (104) and the circuit board (108).

5. The electronic device (100) according to at least one of claims 2 to 4, wherein the at least one electroconductive elastic element (110) is a part of the at least one pedestal (104).

6. The electronic device (100) according to at least one of claims 2 to 4, wherein the at least one electroconductive elastic element (110) is a separate means attached to the at least one pedestal (104).

7. The electronic device (100) according to at least one of claims 2 to 6, wherein the at least one pedestal (104) extends between the at least one electronic component (106) and the heat sink (102) along an axis (E) and is in thermal contact with the at least one electronic component (106) and the heat sink (102).

8. The electronic device (100) according to at least one of claims 2 to 7, further comprising:
- a thermal interface material (112) arranged between the at least one electronic component (106) and the at least one pedestal (104).

9. The electronic device (100) according to at least one of claims 2 to 8, wherein the at least one electroconductive elastic element (110) comprises a first end (114) and a second end (116), wherein the first end (114) of the at least one electroconductive elastic element (110) comprises a first elastic element configured to connect the first end (114) of the at least one electroconductive elastic element (110) to the at least one pedestal (104), and wherein the second end (116) of the at least one electroconductive elastic element (110) comprises a second elastic element configured to connect the second end (116) of the at least one electroconductive elastic element (110) to the circuit board (108).

10. The electronic device (100) according to at least one of claims 1 to 9, wherein the at least one electroconductive elastic element (110) is attached to the circuit board (108) such that the at least one electroconductive elastic element (110) is grounded to the circuit board (108).

11. The electronic device (100) according to at least one of claims 1 to 10, wherein the at least one electroconductive elastic element (110) is configured to ground current loops escaping from the at least one electronic component (106) back to a grounding (134) of the circuit board (108).

12. The electronic device (100) according to at least one of claims 2 to 11, wherein the at least one electroconductive elastic element (110) is configured to compensate tolerances at respective connection points (128, 129) between the at least one electroconductive elastic element (110) and the at least one pedestal (104) and between the at least one electroconductive elastic element (110) and the circuit board (108).

13. The electronic device (100) according to at least one of claims 1 to 12, wherein the at least one electroconductive elastic element (110) is arranged around the at least one electronic component (106).

14. The electronic device (100) according to at least one of claims 1 to 13, wherein the electronic device (100) comprises a plurality of electronic components (106) arranged spaced apart on the circuit board (108) and the at least one electroconductive elastic element (110) is arranged around the plurality of electronic components (106),
wherein the at least one electroconductive elastic element (110) is configured to shield the plurality of electronic components (106) from electromagnetic emission.

15. The electronic device (100) according to claim 14,
wherein the electronic device (100) comprises a plurality of pedestals (104), each of the plurality of pedestals (104) being arranged between a respective electronic component (106) of the plurality of electronic components (106) and the heat sink (102), and
wherein the at least one electroconductive elastic element (110) is attached to each pedestal (104) of the plurality of pedestals (104) and the circuit board (108).
